# NEUE EUROPÄISCHE PATENTSCHRIFT

(11) **EP 0 965 255 B2**
(45) Veröffentlichungstag und Bekanntmachung des Hinweises auf die Entscheidung über den Einspruch: **20.10.2010**
(45) Hinweis auf die Patenterteilung: 01.03.2006
(21) Anmeldenummer: 98919059.0
(22) Anmeldetag: 05.03.1998
(51) Int. Cl.: H05K 9/00

(54) **VERFAHREN ZUR HERSTELLUNG EINES ABSCHIRMGEHÄUSES**
METHOD FOR PRODUCING A SHIELDING CASE
PROCEDE POUR FABRIQUER UN BOITIER DE BLINDAGE

(30) Priorität: 05.03.1997 DE 19713524
(43) Veröffentlichungstag der Anmeldung: 22.12.1999
(60) Teilanmeldung: 01105941.7
(73) Patentinhaber: Tiburtius, Bernd, 14532 Kleinmachnow (DE); Kahl, Helmut, 12307 Berlin (DE)
(72) Erfinder: Tiburtius, Bernd, 14532 Kleinmachnow (DE); Kahl, Helmut, 12307 Berlin (DE)
(74) Vertreter: Keussen, Christof
(86) Internationale Anmeldenummer: PCT/DE1998/000682
(87) Internationale Veröffentlichungsnummer: WO 1998/039957

(56) Entgegenhaltungen:
- EP-A- 0 410 701
- EP-A- 0 629 114
- DE- - 19 733 627
- JP- - 61- 149 399

## Beschreibung

Die Erfindung betrifft ein Verfahren zur Herstellung eines Abschirmgehäuses gemäß dem Oberbegriff des Anspruchs 1, sowie eine elektrisch leitfähige Dichtung gemäß dem Oberbegriff des Anspruchs 10.

Elektrisch abschirmende Gehäuse zur Aufnahme und elektromagnetischen Abschirmung von elektromagnetische Strahlung emittierenden oder gegenüber elektromagnetischer Strahlung empfindlichen Baugruppen sind seit langem bekannt.

Während solche Gehäuse früher aus naheliegenden Gründen zumeist aus Metall gefertigt wurden, ist mit dem Einsetzen ihrer massenhaften Verbreitung - beispielsweise bei Mobiltelefonen oder schnurlosen Telefonen - aus Kosten- und Gewichtsgründen dazu übergangangen worden, sie insbesondere aus Kunststoff zu fertigen. Die vorgefertigten, insbesondere spritzgegossenen, Gehäuseteile werden mit einem leitfähigen Material beschichtet, etwa durch Aufspritzen von Leitlack, Bedampfen mit Aluminium oder Galvanisieren.

Solche Gehäuse wurden zunächst in der Regel mit vorgefertigten Dichtungen versehen, die aus leitfähigem Elastomer bestehen und bei der Montage eingelegt werden. DE 38 12 943 A1 zeigt ein innenbeschichtetes Abschirmgehäuse aus faserverstärktem Kunststoff mit einer solchen vorgefertigten, zwischen Nut und Feder eingelegten Dichtung.

Gehäuse der oben genannten Art sind auch aus EP 0 629 114 B1 sowie aus EP 0 654 962 A1 bekannt.

Die dort beschriebenen Gehäuse sind aus zwei Teilen zusammengesetzt, die zur elektrischen Abschirmung des Gehäuseinnenraums (mindestens abschnittsweise) aus elektrisch leitfähigem Material bestehen oder mit solchem beschichtet sind und im zusammengesetzten Zustand einen Faradayschen Käfig bilden. Zur elektromagnetischen Abschirmung des Gehäuses im Fugenbereich zwischen den aneinanderstoßenden Gehäuseteilen ist eine Abschirmdichtung vorgesehen, die aus einem elektrisch leitfähigen und zugleich elastischen Material besteht und sich an Oberflächentoleranzen und -unebenheiten anpaßt, so daß auch bei Großserienfertigung eine sehr hohe Qualtität der Abschirmung des Gehäuseinneren gewährleistet werden kann. Diese Abschirmdichtung ist direkt auf mindestens einem der Gehäuseteile gefertigt, wobei noch ein zusätzlicher Träger in den Aufbau einbezogen sein kann.

Durch diesen Aufbau läßt sich das Gehäuse beispielsweise zu Wartungszwecken oder zur Ersetzung einer Energiequelle öffnen und anschließend - unter Erhaltung der Dicht- und Abschirmwirkung - wieder einfach verschließen.

Bei der Herstellung eines Materials für die Abschirmdichtung hat es sich jedoch als schwierig erwiesen, einen optimalen Kompromiß zwischen hoher Elastizität, hoher Leitfähigkeit und möglichst niedrigen Materialkosten zu finden. Ein Material mit vorteilhaft hoher Abschirmwirkung ist eine mit einem hohen Anteil von Silberpulver gefüllte Kunststoffmasse, diese ist aber relativ teuer und hat nur bedingt zufriedenstellende mechanische Eigenschaften.

In DE 39 34 845 A1 wird die Herstellung eines Abschrirmgehäuses mit einem zweischichtigen Abschirmprofil durch Auftragen eines elastischen, aber nicht leitfähigen Dichtprofils auf ein Gehäuseteil und anschließendes Aufsprühen einer leitfähigen Beschichtung auf dieses Dichtprofil beschrieben. Dieses Verfahren ermöglicht grundsätzlich die Einsparung von Materialkosten, ist aber technologisch aufwendig und ergibt Dichtungen, deren mechanische und insbesondere elektromagnetische Eigenschaften nicht völlig überzeugen können.

Auch die in WO97/26782 durch die Anmelderin vorgeschlagene Lösung erfordert - sofern das Dichtprofil auf ein Gehäuseteil aufdispensiert wird - einen zusätzlichen Verfahrensschritt und ermöglicht nur die Ausbildung relativ dünner leitfähiger Beschichtungen.

Der Erfindung liegt somit die Aufgabe zugrunde, ein Verfahren zur Herstellung eines Abschirmgehäuses der eingangs genannten Art bereitzustellen, das eine einfache und kostengünstige Herstellung von Abschirmgehäusen mit sehr guten mechanischen und elektromagnetischen Eigenschaften und hoher Lebensdauer ermöglicht.

Diese Aufgabe wird durch ein Verfahren mit den im Anspruch 1 angegebenen Merkmalen gelöst. Anspruch 10 betrifft ein Gehäuseteil eines Abschirmgehäuses mit einer erfindungsgemäßen elektrisch leitfähigen Dichtung.

Die Erfindung schließt die technische Lehre ein, das Abschirmprofil in einem einzigen Auftragsschritt aus (mindestens) zwei verschiedenen, elastisch aushärtenden, aber auf unterschiedliche Funktionen hin optimierten Komponenten derart zu bilden, daß diese fest und dauerhaft miteinander verbunden sind und so eine zuverlässig bifunktionelle Einheit bilden.

Indem als einzelner Auftragsschritt das Ausdrücken aus einer Nadel bzw. Düse mit mindestens einem ersten und einem zweiten Kanal vorgesehen ist, können beide Komponenten mit hoher Prozeßgeschwindigkeit in für eine ausgezeichnete Dicht- bzw. Abschirmwirkung ausreichender Dicke auf das Gehäuse aufgebracht werden. Da die Oberflächen beider Komponenten im Ausgangszustand, also vor Einsetzen jedweder Vernetzung bzw. Härtung, miteinander in Kontakt gebracht werden, vernetzen diese miteinander bzw. es wird eine Diffusions-Grenzschicht ausgebildet, was eine praktisch unlösbare Verbindung beider Profilteile gewährleistet.

Der aus dem ersten Material gebildete Profilteil bzw. -abschnitt hat primär die Funktion, den Fugenzwischenraum auszufüllen, um trotz eines durch Fertigungstoleranzen oder Oberflächenunebenheiten verursachten mechanischen Spiels der Gehäuseteile das Gehäuseinnere zuverlässig gegen Feuchtigkeit und Staub zu schützen und ggfs. Relativbewegungen zwischen den Gehäuseteilen zu verhindern. Aufgrund der mechanisch optimierten Eigenschaften des ersten Materials ist es möglich, den Gehäuseinnenraum dauerhaft hermetisch abzudichten. Zugleich ist der erste Profilteil natürlich Träger eines Abschnitts der elektromagnetischen Abschirmung und sichert deren Geschlossenheit. Besonders vorteilhaft ist es im Hinblick hierauf, ein hochgradig elastisches Material und/oder eine formelastische Gestalt der Dichtung zu wählen, aufgrund derer bei der Montage der Gehäuseteile durch die Kompression und/oder eine Flexion des Dichtelements eine Vorspannung zwischen den Gehäuseteilen aufgebaut wird, die beispielsweise die Lösung einer Schraub- oder Klemmverbindung verhindern kann.

In einer vorteilhaften Variante der Erfindung ist vorgesehen, daß als zweites Material ein durch elektrisch leitende Einschlüsse leitfähig gemachtes Kunststoffmaterial der gleichen Art wie das erste Material eingesetzt wird. Die hierdurch erreichte weitgehende Materialeinheitlichkeit dient zur Vertiefung der oben angesprochenen Wirkung.

Die Herstellung des Abschirmprofils wird durch den Einsatz eines luft- umd raumtemperaturhärtenden und insbesondere thixotrope Eigenschaften aufweisenden Kunststoffmaterials, speziell auf Siliconbasis, in vorteilhaften. Weise technologisch vereinfacht und verbilligt, alternativ ist aber auch warmhärtendes oder strahlungsvernetzendes Material einsetzbar.

Als elektrisch leitende Einschlüsse werden zur Erzielung einer den hohen Prüfanforderungen gerecht werdenden Abschirmwirkung speziell Teilchen aus einem Metall oder einer Legierung mit hoher elektrischer Leitfähigkeit, insbesondere Silber oder einer silberhaltigen Legierung, beigemischt. Kostengünstiger ist der Einsatz eines versilberten Pulvers aus einem anderen Metall (Nickel, Kupfer o.ä.) oder von nichtleitenden Trägerpartikeln (z.B. aus Glas). Der Metallgehalt liegt typischerweise bei über 25 Masse-%, zur Erzielung höchster Abschirmeffekte bei Mobiltelefonen etc. ggfs. sogar deutlich über 50 Masse-%, bezogen auf die Masse der Silicon-Metall-Mischung.

Neben Metallpulver ist insbesondere auch der Einsatz von Metall-Kurzfasern oder -plättchen vorgesehen, die in der Kunststoffmatrix bei geeigneter Vorgabe ihrer Abmessungen in Abstimmung auf die Eigenschaften des Matrix-Materials und die Verfahrenskenngrößen in vorteilhafter Weise eine Art Metallgerüst ausbilden können. Dieses kann dem leitfähigen Profilteil eine hohe Leitfähigkeit bei relativ geringem Metallanteil verleihen und in Verbindung hiermit zugleich zu Vorteilen hinsichtlich einer relativ geringen Härte und Sprödigkeit führen.

Für Anwendungsfälle, in denen eine Angleichung der Härtegrade des ersten und zweiten Materials gewünscht ist, kann dem ersten Material ein nicht leitfähiger Füllstoff, insbesondere ein kostengünstiges oxidischer oder keramisches Pulver (SiO₂, Silicate o.ä.), beigemischt werden.

Je nach den spezifischen Materialeigenschaften der Gehäuseoberfläche, auf die das Dicht- und Abschirprofil aufgetragen wird, kann zur Erhöhung des Haftvermögens an dieser beim Auftragen des ersten und/oder zweiten Materials ein Haftvermittler eingesetzt werden. Dieser kann insbesondere dem Material beigemischt sein; alternativ kann er aber auch vorab - etwa im Zuge der Oberflächenbehandlung der Gehäuseteile - aufgebracht werden.

Bei der Herstellung von Gehäusen, bei denen die Möglichkeit eines Öffnens und Wiederverschließens vorzusehen ist, wird das zweite Gehäuseteil bevorzugt erst nach im wesentlichen vollständiger Aushärtung des ersten und/oder zweiten Materials mit dem Dicht- und Abschirmprofil in Berührung gebracht. Dadurch erfolgt kein Anhaften an dem zweiten Gehäuseteil, und es ergibt sich eine sehr hohe Form- und Funktionsbeständigkeit des Profils auch bei mehrmaligem Öffnen und Wiederverschließen des Abschirmgehäuses.

Zur Ausbildung bevorzugter Profilformen wird beim Auftragen des Dicht- und Abschirmprofils eine Auftragsnadel/-düse eingesetzt, bei der der erste Kanal vollständig von dem zweiten Kanal umgeben ist. Speziell kann eine Auftragsnadel oder Düse eingesetzt werden, deren erster Kanal im wesentlichen kreisförmigen Querschnitt hat und konzentrisch von dem zweiten Kanal umgeben ist, wobei dieser im wesentlichen kreisringsegmentförmigen Querschnitt aufweist.

Nadelform und -querschnitt werden in einer für viele Anwendungen zu bevorzugenden Ausführung so gewählt, daß das zweite Material im Profilquerschnitt mit ungleichmäßiger Dicke aufgetragen wird. Insbesondere kann das zweite Material auf der Innenseite des Gehäuses mit größerer Dicke als in dem einem Gehäuseteil zugewandten Abschnitt und/oder auf der Außenseite des Gehäuses aufgetragen werden, wodurch eine tendentiell "weichere" Dichtung realisiert werden kann. Durch Auftragen des zweiten Materials nur auf der Innenseite des Profils kann beispielsweise Problemen entgegengewirkt werden, die sich aus einer möglichen Korrosion der Metallfüllung des zweiten Materials, speziell in extremen Einsatzfeldern (Tropen, Hochseeschiffahrt etc.), ergeben können.

In einer nicht erfindungsgemäßen Variante wird das Abschirmprofil durch gleichzeitigen Auftrag dreier Materialstränge in Sandwich-Bauweise aus einer dreikanaligen Nadel aufgebaut, indem zwei Stränge aus Material vom mechanisch optimierten Typ ("ersten Material") und zwischen diesen ein Strang aus elektrisch leitfähigem Material aufgebracht werden, welcher die elektromagnetische Abschirmung bewirkt. Durch die Anordnung des aus elektrisch leitfähigem Material bestehenden Profilteils in einem im wesentlichen deformationsfreien Bereich zwischen zwei deformierbaren Schichten bzw. Strängen des elastischen Elements wird vorteilhaft einer Rißbildung in dem elektrisch leitfähigen Material entgegengewirkt, was speziell für Konstruktionen von Bedeutung ist, bei denen eine starke Deformation des Abschirmelements beim Zusammensetzen der Gehäuseteile auftreten kann. Diese Anordnung ist zudem besonders korrosionsbeständig.

Zur Gewinnung eines für das Verfahren geeigneten Ausgangsmaterials kann einem vernetzbaren, durch die Vernetzung aushärtenden Silikonkautschuk unter Bildung eines gelartigen Zustandes ein langkettiges, nichtvernetzendes Siloxan beigemischt werden. Das aus einer solchen Mischung gebildete Dicht- und Abschirmprofil zeichnet sich durch hohe Haftfestigkeit auf der Unterlage sowie eine auf geringe Werte einstellbare Shore A-Härte und hohen möglichen Deformationsgrad aus. Relativ weiche und dennoch mechanisch ausreichend beständige EMI-Abschirmprofile können mit Materialien erzeugt werden, die etwa 5 Masse-% bifunktionelles nicht-vernetzendes Siloxan, beispielsweise (Poly-)Dimethylsiloxan mit Methyl- oder Hydroxylendgruppen, mit einer Viskosität im Bereich zwischen 10 und 10³ mPa.s enthalten. In einer für bestimmte Anwendungen vorteilhaften Fortbildung kann des weiteren ein Siliconharz-Anteil im Dichtungsmaterial vorgesehen sein, bevorzugt ein Anteil von über 3 Masse-% einer Lösung einer handelsüblichen warm- oder strahlungshärtenden Harzkomponente.

Der Deformationsgrad eines annähernd U-förmigen zweikomponentigen Dicht- und Abschirmprofils aus Vollmaterial kann (bezogen auf die Höhe des unbelasteten Profils) 30% oder mehr, für bestimmte Anwendungen bevorzugt bis über 50%, betragen. Durch spezielle Profilquerschnittsgestaltungen, etwa die Wahl eines zugleich kompressiblen und biegeverformbaren Lippenprofils, sind effektiver Deformationsgrad und Rückstellkraft des Profils zusätzlich gezielt beeinflußbar. Durch die genannten verfahrensseitigen und ggfs. zusätzlichen geometrischen Maßnahmen lassen sich auch Spalte mit über den Längsverlauf erheblich differierender Breite zuverlässig abschirmend abdichten. Dies erlaubt in kostensenkender Weise größere Toleranzen bei der Vorfertigung der Gehäuseteile.

Vorteilhafte Weiterbildungen der Erfindung sind im übrigen in den Unteransprüchen gekennzeichnet bzw. werden nachstehend zusammen mit der Beschreibung bevorzugter Ausführungen anhand der Figuren näher dargestellt. Es zeigen:
- Figur 1: eine Prinzipdarstellung zur Ausführung der Erfindung und
- die Figuren 2a bis 2j: schematische Querschnittsdarstellungen von Dicht- und Abschirmprofilen gemäß bevorzugten Ausführungsformen und den zu deren Herstellung jeweils eingesetzten Auftragsnadeln, wobei nur die Ausführungsformen der Figuren 2g und 2h erfindungsgemäß sind.

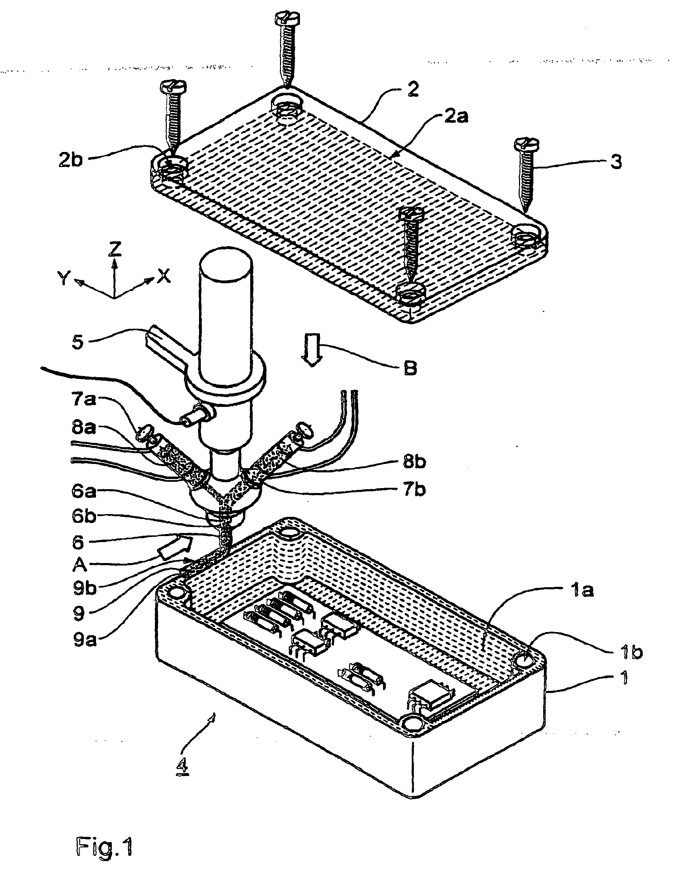

Fig. 1 zeigt in einer Prinzipskizze ein Gehäuse-Unterteil 1 und einen Gehäusedeckel 2 aus spritzgegegossenem Kunststoff für ein elektronisches Gerät (in praxi z.B. ein Mobiltelefon), die beide mit einer innenseitigen Metallisierungsschicht 1a bzw. 2a versehen sind. In beide Gehäuseteile 1, 2 sind Schraubenlöcher 1b bzw. 2b eingeformt, wobei die Schraubenlöcher 1b im Gehäuse-Unterteil zum partiell selbstschneidenden Eindrehen von Gewindeschneidschrauben 3 ausgebildet sind und die Schraubenlöcher 2b im Dekkel jeweils eine Senkung zur Aufnahme des Schraubenkopfes der Schrauben 3 aufweisen. Mit dieser Schraubverbindung wird ein bedarfsweise wiederholtes Öffnen und Wiederverschließen des Gerätegehäuses 4 ermöglicht.

In der Figur ist skizziert, wie ein Arm 5 einer (als solche nicht insgesamt dargestellten) koordinatengesteuerten Handhabevorrichtung eine zwei konzentrisch verlaufende Kanäle 6a, 6b aufweisende Auftragnadel 6 mit Schlauchanschlüssen 7a, 7b zur Zuführung zweier unter Druck stehender Dichtungs-Ausgangsmaterialien 8a, 8b in Richtung des Pfeils A über den Kantenabschnitt des Gehäuse-Unterteils 1 führt. Dabei wird ein annähernd U-förmiger Dicht- und Abschirmmaterialstrang 9, dessen Kern 9a aus dem ersten Ausgangsmaterial 8a und dessen Oberflächenschicht 9b aus dem zweiten Ausgangsmaterial 8b besteht, auf den Kantenabschnitt aufdispensiert und haftet dort fest an.

Das erste Ausgangsmaterial 8a ist eine in einen pastösgelartigen Zustand eingestellte, ungefüllte luft- und raumtemperaturhärtende Siliconmischung, das zweite Ausgangsmaterial 8b ist eine pastös eingestellte, mit einem Anteil von etwa 50 Masse-% versilberter Nickelteilchen gefüllte Silikon-Leitmischung, deren Matrix im wesentlichen die gleiche Zusammensetzung hat wie das erste Material 8a, der aber zusätzlich in einem Anteil von weniger als 1 Masse-% ein Tensid als Haftvermittler beigemischt ist.

Nach dem Austreten aus der Nadel 6 beginnt sofort von der Oberfläche her - ohne zusätzliche technische Maßnahmen - die Aushärtung des Materialstranges 9 zu einem elastischen, frei geformten Dicht- und Abschirmprofil mit einem weichen Kern und einer hoch leitfähigen, aber ebenfalls noch relativ elastischen, den Kern allseitig ummantelnden Oberflächenschicht. Nachdem die Aushärtung im wesentlichen abgeschlossen ist, wird - wie mit dem Pfeil B symbolisiert - der Deckel 2 auf das Unterteil 1 aufgesetzt und über die Schrauben 3 mit diesem verschraubt, wobei der zum Dicht- und Abschirmprofil verfestigte Strang 9 ohne Anhaften an den Deckel 2 elastisch verformt wird und den Spalt zwischen den Gehäuseteilen 1, 2 zuverlässig abdichtet und abschirmt.

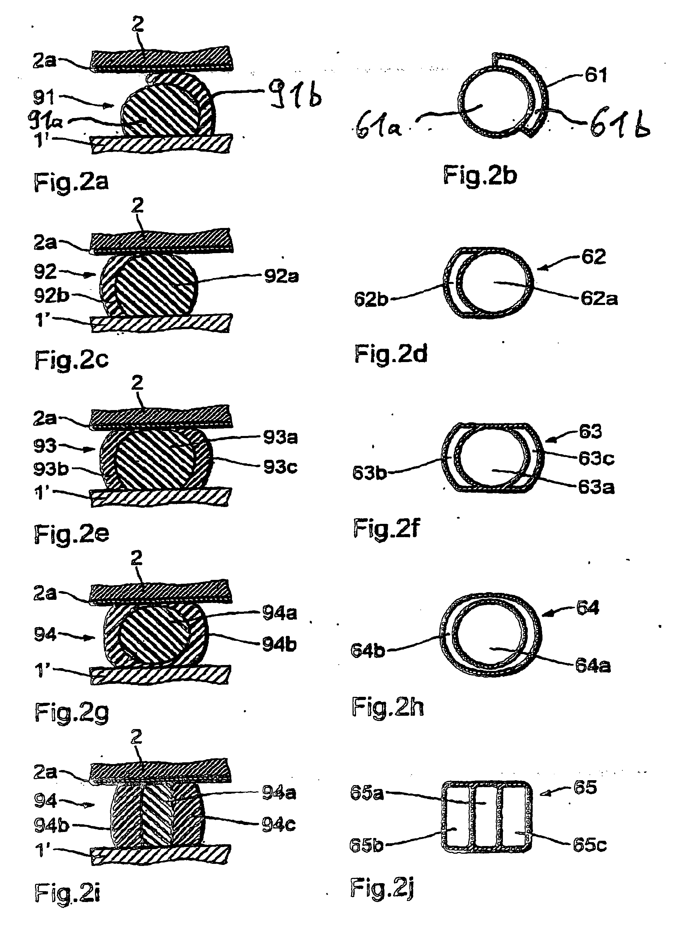

In den Fig. 2a bis 2j sind in Querschnittsdarstellungen verschiedene Dicht- und Abschirmprofile gemäß bevorzugten Ausführungsformen zusammen mit den zu deren Herstellung jeweils eingesetzten Auftragsnadeln gezeigt. Die fertigen Profile sind jeweils mit Ausschnitten der benachbarten Gehäueoberflächen 1' bzw. 2 gezeigt, wobei 1' (im Unterschied zur Spezifikation bei Fig. 1) für ein metallisches Gehäuseunterteil steht, während als Material für den Dekkel 2 wieder Kunststoff mit einer Metallbeschichtung 2a gewählt ist. (Natürlich ist die Erfindung auch bei einem Ganzmetallgehäuse anwendbar.)

Das Dicht- und Abschirmprofil 91 gemäß Fig. 2a besteht aus einem nicht leitfähigen Basisteil 91a und einer dieses über etwas mehr als die Hälfte des Umfangs bedeckenden leitfähigen Schicht 91b und wird mittels einer in Fig. 2b skizzierten Auftragsnadel 61 mit einem ersten Kanal 61a mit kreisförmigem Querschnitt und einem diesen partiell umgebenden zweiten Kanal 61b mit kreisringsegmentförmigem Querschnitt auf das Gehäuseteil 1' aufgebracht.

Das Dicht- und Abschirmprofil 92 gemäß Fig. 2c besteht aus einem nicht leitfähigen Basisteil 92a und einem dieses über etwas weniger als die Hälfte des Umfangs reichenden leitfähigen Flankenteil 92b und wird mittels einer in Fig. 2d gezeigten Auftragsnadel 62 mit einem ersten Kanal 62a mit kreisformigem Querschnitt und einem diesen partiell umgebenden zweiten Kanal 62b mit annähernd kreisringsegmentförmigem Querschnitt auf das Gehäuseteil 1' aufgebracht.

Das Dicht- und Abschirmprofil 93 gemäß Fig. 2e unterscheidet sich von dem nach Fig. 2c darin, daß beidseitig eines nicht leitfähigen Basisteils 93a jeweils ein über etwas weniger als die Hälfte des Umfangs reichendes leitfähiges Profilteil 93b, 93c vorgesehen ist. Das Profil 93 wird mittels einer in Fig. 2d gezeigten Auftragsnadel 63 mit einem ersten Kanal 63a mit kreisförmigem Querschnitt und zwei seitlich hiervon angeordneten Kanälen 63b, 63c mit annähernd kreisringsegmentförmigem Querschnitt erzeugt.

Bei dem Dicht- und Abschirmprofil 94 gemäß Fig. 2g ist ein nicht leitfähiges Kernteil 94a vollständig mit einer leitfähigen Schicht 94b ummantelt, deren Dicke aber in Nachbarschaft zu den Gehäuseteilen 1',2 geringer im Spaltraum ist. Dieses Profil 94 wird mittels einer in Fig. 2h skizzierten Auftragsnadel 64 mit einem ersten Kanal 64a mit kreisförmigem Querschnitt und einem diesen umgebenden zweiten Kanal 64b mit ellipsoidischem Querschnitt gebildet.

Das Dicht- und Abschirmprofil 95 gemäß Fig. 2i hat einen ähnlichen (dreikomponentigen) Aufbau wie das in Fig. 2e gezeigte, jedoch ist die Materialzuordnung anders: Beidseitig eines leitfähigen, abschirmenden Mittelteils 95a ist jeweils ein nicht leitfähiges, abdichtendes Profilteil 95b, 95c vorgesehen. Das Profil 95 wird mittels einer in Fig. 2d gezeigten Auftragsnadel 65 mit drei nebeneinander angeordneten Kanälen 65a bis 65c mit annähernd rechteckigem Querschnitt erzeugt.

Die Erfindung beschränkt sich in ihrer Ausführung nicht auf die vorstehend angegebenen bevorzugten Ausführungsbeispiele. Vielmehr ist eine Anzahl von Varianten möglich, welche von der dargestellten Lösung auch in anders gearteten Ausführungen Gebrauch macht.

So ist die Spezifikation des ersten Materials als "nicht leitfähig" im weiteren Sinne dahingehend zu verstehen, daß dieses Material eine deutlich geringere Leitfähigkeit (z.B. entsprechend einem deutlich geringeren metallischen Füllungsgrad) als das zweite Material aufweist. Der Einsatz eines Kunststoffs auf Siliconbasis ist nicht zwingend; es kann auch ein Neopren- oder anderes elastisch aushärtendes Material eingesetzt werden, das auch nicht unbedingt raumtemperaturhärtend sein muß.

Die Geometrie des zu erzeugenden Profils und die daraufhin zu wählende Nadel- bzw. Düsenquerschnittsform hängen vom Einsatzzweck und der konkreten Gestalt des Abschirmgehäuses ab, und neben den in Fig. 2a bis 2j skizzierten Varianten sind viele andere brauchbar.

## Patentansprüche

1. Verfahren zur Herstellung eines Abschirmgehäuses (4), wobei das Abschirmgehäuse (4) ein Gehäuse-Unterteil (1, 1') und einen Gehäusedeckel (2) als erstes bzw. zweites Gehäuseteil aufweist, zum mechanischen Schutz und zur elektromagnetischen Abschirmung einer elektronischen Funktionseinheit, bei dem ein einen Spalt zwischen dem ersten und dem zweiten benachbarten Gehäuseteil (1; 2; 1') ausfüllendes Dicht- und Abschirmprofil (9; 91 bis 95) vorgesehen ist, welches aus pastösem Material unter Druck aus einer eine Auftragnadel oder -düse (6; 61 bis 65) aufweisenden koordinatengesteuerten Auftragvorrichtung (5) direkt auf das erste Gehäuseteil (1; 1', 2) aufgetragen wird und sich dort anschließend unter Anhaften an diesem freitragend elastisch verfestigt,
**dadurch gekennzeichnet, dass**
das Dicht- und Abschirmprofil durch gleichzeitiges Auftragen mindestens eines ersten Materials (8a) mit auf eine gute Dichtwirkung abgestimmten Materialeigenschaften und eines zweiten, sich ebenfalls elastisch verfestigenden Materials (8b) mit auf eine gute Abschirmwirkung abgestimmten Materialeigenschaften aus der mit mindestens einem ersten und einem zweiten Kanal (6a, 6b; 61a, 61b; 62 a, 62b; 63a bis 63c; 64a, 64b; 65a bis 65c) versehenen Auftragnadel bzw. -düse erzeugt wird, wodurch das zweite Material, am ersten Material fest anhaftet und wobei der erste Material einen Strang bildet, der vollständig von dem zweiten Material umhüllt ist, wobei bei der Auftragsnadel bzw. -düse der erste Kanal vollständig von dem zweiten Kanal umgeben ist.

2. Verfahren nach Anspruch 1, **dadurch gekennzeichnet, dass** das zweite Gehäuseteil (2) nach im Wesentlichen vollständiger Aufhärtung des ersten und/oder zweiten Materials (8a, 8b) mit dem Dicht- und Abschirmprofil (9; 91 bis 95) in Berührung gebracht wird.

3. Verfahren nach Anspruch 1 oder 2, **dadurch gekennzeichnet, dass** als erstes Material (8a) ein im Wesentlichen nicht leitfähiges, luft- und raumtemperaturhärtendes und insbesondere thixotrope Eigenschaften aufweisendes Kunststoffmaterial, insbesondere auf Siliconbasis, und als zweites Material (8b) ein durch elektrisch leitende Einschlüsse leitfähig gemachtes Kunststoffmaterial der gleichen Art wie das erste Material eingesetzt wird.

4. Verfahren nach Anspruch 3, **dadurch gekennzeichnet, dass** als elektrisch leitende Einschlüsse Teilchen, insbesondere Fasern oder Plättchen, aus einem Metall oder einer Legierung mit hoher elektrischer Leitfähigkeit, insbesondere Silber oder einer silberhaltigen Legierung, eingesetzt werden.

5. Verfahren nach Anspruch 3, **dadurch gekennzeichnet, dass** das erste Material (8a) einen nicht leitfähigen, insbesondere oxidischen oder keramischen, Füllstoff enthält.

6. Verfahren nach einem der vorhergehenden Ansprüche, **dadurch gekennzeichnet, dass** beim Auftragen des ersten und/oder zweiten Materials (8a, 8b) ein Haftvermittler eingesetzt wird, der insbesondere dem Material beigemischt ist.

7. Verfahren nach Anspruch 6, **dadurch gekennzeichnet, dass** zum Auftragen des Dicht- und Abschirmprofils eine Auftragnadel oder Düse (6; 61 bis 64) eingesetzt wird, deren erster Kanal (6a; 61a; 62a; 63a; 64a) im Wesentlichen kreisförmigen Querschnitt hat und konzentrisch von dem zweiten Kanal (6b; 61b; 62b; 63b; 63c; 64b) umgeben ist.

8. Verfahren nach einem der vorhergehenden Ansprüche, **dadurch gekennzeichnet, dass** das zweite Material im Profilquerschnitt mit ungleichmäßiger Dicke aufgetragen wird.

9. Verfahren nach Anspruch 8, **dadurch gekennzeichnet, dass** das zweite Material auf der Innenseite des Gehäuses mit größerer Dicke als in dem einem Gehäuseteil zugewandten Abschnitt und/oder auf der Außenseite des Gehäuses aufgetragen wird.

10. Gehäuseteil eines ein Gehäuse-Unterteil und einen Gehäusedeckel aufweisenden Abschirmgehäuses mit einer direkt auf das Gehäuseteil aufgetragenen Dichtung, wobei die Dichtung elektrisch leitfähig ist und ein strangförmiges Dicht- und Abschirmprofil aufweist, bestehend aus einem ersten Material und einem zweiten Material, wobei das erste Material ein im Wesentlichen nicht leitfähiges, mit auf eine gute Dichtwirkung abgestimmten Materialeigenschaften ausgebildetes Material ist, und das zweite Material ein durch elektrisch leitende Einschlüsse auf eine gute Abschirmwirkung abgestimmten Materialeigenschaften ausgebildetes Material ist, wobei das erste Material einen Strang bildet, welcher von einem Strang aus dem zweiten Material vollständig umhüllt ist, wobei das Dicht- und Abschirmprofil mit einer Auftragsnadel/-düse aufgetragen ist, bei der ein erster Kanal vollständig von einem zweiten Kanal umgeben ist.

11. Gehäuseteil nach Anspruch 10, **dadurch gekennzeichnet, dass** als elektrisch leitende Einschlüsse für das zweite Material Teilchen, insbesondere Fasern oder Plättchen, aus einem Metall oder einer Legierung mit hoher elektrischer Leitfähigkeit, insbesondere Silber oder einer silberhaltigen Legierung eingesetzt werden.

12. Gehäuseteil nach Anspruch 10, **dadurch gekennzeichnet, dass** das erste Material einen nicht leitenden, insbesondere oxidischen oder keramischen Füllstoff enthält.

13. Gehäuseteil nach einem der Ansprüche 10 bis 12, **dadurch gekennzeichnet, dass** dem ersten und/oder zweiten Material ein Haftvermittler beigemischt ist.

14. Gehäuseteil nach einem der Ansprüche 10 bis 13, **dadurch gekennzeichnet, dass** der Strang des ersten Materials einen im Wesentlichen kreisförmigen Querschnitt aufweist und konzentrisch von dem Strang des zweiten Materials umgeben ist.

15. Gehäuseteil nach einem der Ansprüche 10 bis 14, **dadurch gekennzeichnet, dass** das zweite Material im Profilquerschnitt eine ungleichmäßige Dicke aufweist.

## Claims

1. Method for the manufacture of a screening enclosure (4), the screening enclosure (4) comprising an enclosure bottom part (1, 1') and an enclosure cover (2) as first respectively second enclosure parts for the mechanical protection and electromagnetic screening of an electronic functional unit, in which a sealing and screening profile (9; 91 to 95) filling a gap between the first and the second adjoining enclosure part (1, 2; 1') is provided the profile of pasty material being applied under pressure from a co-ordinate-controlled application device (5) having an application needle or nozzle (6; 61 to 65) directly onto the first enclosure part (1; 1'), where unsupported it then solidifies elastically whilst adhering to the latter, **characterized in that** the sealing and screening profile is produced by the simultaneous application of at least a first material (8a) having material characteristics adapted for a good sealing effect and a second material (8b), likewise solidifying elastically and having material characteristics adapted for a good screening effect, from the application needle or nozzle provided with at least a first and a second duct (6a, 6b; 61a, 61b; 62a, 62b; 63a to 63c; 64a, 64b; 65a to 65c), with the result that the second material adheres firmly to the first material, and the first material forming a strand which is entirely enveloped by a strand of the second material, the first duct being completely surrounded by the second duct in the application needle or nozzle.

2. Method according to Claim 1, **characterized in that** the second enclosure part (2) is brought into contact with the sealing and screening profile (9; 91 to 95) after essentially complete setting of the first and/or second material (8a, 8b).

3. Method according to Claim 1 or 2, **characterized in that** an essentially non-conductive plastic material, especially a silicone-based plastic, setting at air and room temperature and in particular one having thixotropic characteristics, is used as first material (8a) and a plastic material of the same type as the first material, rendered conductive by electrically conductive inclusions, is used as second material (8b).

4. Method according to Claim 3, **characterized in that** particles, in particular fibres or flakes, of a metal or an alloy having high electrical conductivity, in particular silver or an alloy containing silver, are used as electrically conductive inclusions.

5. Method according to Claim 3, **characterized in that** the first material (8a) contains a non-conductive, in particular an oxidic or ceramic filler.

6. Method according to one of the preceding claims, **characterized in that** when applying the first and/or second material (8a, 8b) an adhesion primer is used, which in particular is added to the material.

7. Method according to Claim 6, **characterized in that** for application of the sealing and screening profile an application needle or nozzle (6; 61 to 64) is used, the first duct (6a; 61a; 62a; 63a; 64a) of which essentially has a circular cross section and is concentrically surrounded, at least in sections, by the second duct (6b; 61b; 62b; 63b, 63c; 64b) the latter having an essentially circular segmental cross section.

8. Method according to one of the preceding claims, **characterized in that** the second material in the profile cross section is applied with non-uniform thickness.

9. Method according to Claim 8, **characterized in that** the second material is applied on the inside of the enclosure with greater thickness than in the section facing an enclosure part and/or on the outside of the enclosure

10. Enclosure part of a screening enclosure which comprises an enclosure bottom part and an enclosure cover, having a seal being applied directly onto the enclosure part, the seal being electrically conductive and having a strand-shaped sealing and screening profile, comprising a first material and a second material, the first material being as essentially non-conductive material designed with material characteristics adapted for a good sealing effect, and the second material being a material designed by means of electrically conductive inclusions for material characteristics adapted for a good screening effect, the first material forming a strand which is entirely enveloped by a strand of the second material, the sealing and screening profile being applied with an application needle or nozzle, in which a first duct is completely surrounded by a second duct.

11. Enclosure part according to Claim 10, **characterized in that** particles, in particular fibres or flakes, of a metal or an alloy having high electrical conductivity, in particular silver or an alloy containing silver, are used as electrically conductive inclusions for the second material.

12. Enclosure part according to Claim 10, **characterized in that** the first material contains a non-conductive, in particular an oxidic or ceramic filler.

13. Enclosure part according to one of Claims 10 to 12, **characterized in that** an adhesion primer is added to the first and/or second material.

14. Enclosure part according to one of Claims 10 to 13, **characterized in that** the strand of the first material has an essentially circular cross section and is concentrically surrounded, at least in sections, by the strand of the second material, the latter having an essentially circular segmental cross section.

15. Enclosure part according to one of claims 10 to 14, **characterized in that** the second material in the profile cross section has a non-uniform thickness.

## Revendications

1. Procédé de fabrication d'un boîtier de blindage (4) le boîtier de blindage (4) comprenant und sous-partie de boîtier (1, 1') et un couvercle de boîtier (2) comme premier respectivement second élément de boîtier, servant de protection mécanique et d'écran électromagnétique à une unité fonctionnelle électronique et comprenant un profil d'étanchéité et de blindage (9 ; 91 à 95) qui remplit un intervalle ménagé entre le premier et le second élément de boîtier contigu (1, 2 ; 1'), constitué d'une masse pâteuse appliquée sous pression directement sur le premier élément de boîtier (1 ; 1') à partir d'un dispositif d'application (5) présentant une aiguille ou une buse (6 ; 61 65) commandé par coordonnées et qui se consolide alors de manière élastique en faisant saillie par adhérence sur celui-ci,
**caractérisé en ce que** le profil d'étanchéité et de blindage est réalisé par application simultanée au moins d'un premier matériau (8a) ayant des propriétés adaptées à une bonne action d'étanchéité et d'un second matériau (8b) avec des propriétés adaptées à une bonne action de protection en se consolidant également de manière élastique par l'aiguille et/ou la buse munie au moins d'un premier et d'un second canal (6a, 6b ; 61a, 61b ; 62a, 62b ; 63a à 63c ; 64a, 64b ; 65a à 65c), de sorte que le second matériau adhère fermement au premier matériau, et le premier matériau formant un cordon entouré complètement par un cordon du deuxième matériau, le premier canal étant entouré complètement par le second canal en l'aguille et/ou la buse.

2. Procédé selon la revendication 1, **caractérisé en ce que** le second élément de boîtier (2) est amené en contact avec le profil d'étanchéité et de blindage (9 ; 91 à 95) après un durcissement essentiellement intégral du premier et/ou du second matériau (8a, 8b).

3. Procédé selon la revendication 1 ou 2, **caractérisé en ce que** le premier matériau (8a) utilisé est pour l'essentiel de la matière synthétique non conductrice, durcissant à l'air et à la température ambiante, et ayant notamment des propriétés thixotropes, en particulier à base de silicone, et le second matériau (8b) mis en oeuvre est pour l'essentiel de la matière synthétique de même nature que le premier matériau, rendue conductrice par des inclusions électriquement conductrices.

4. Procédé selon la revendication 3, **caractérisé en ce que** les inclusions électriquement conductrices utilisées sont des particules, notamment des fibres ou des plaquettes en métal ou en alliage notamment de l'argent ou un alliage argentifère, avec une forte conductibilité électrique.

5. Procédé selon la revendication 3, **caractérisé en ce que** le premier matériau (8a) contient une matière de charge non conductrice, en particulier oxydée ou en céramique.

6. Procédé selon l'une des revendications précédentes, **caractérisé en ce qu'**un agent adhésif est utilisé, qui est en particulier mélangé au matériau, pour l'application du premier et/ou second matériau (8a, 8b).

7. Procédé selon la revendication 6, **caractérisé en ce que**, pour appliquer le profil d'étanchéité et de blindage, on utilise une aiguille ou une buse (6 ; 61 à 64) dont le premier canal (6a ; 61a ; 62a ; 63a ; 64a) essentiellement de section circulaire est entouré de manière concentrique au moins par secteurs par le second canal (6b ; 61b ; 62b ; 63b ; 63c ; 64b), celui-ci ayant pour l'essentiel une section circulaire de forme segmentée.

8. Procédé selon l'une des revendications précédentes, **caractérisé en ce que** le second matériau est appliqué avec une épaisseur irrégulière de section du profil.

9. Procédé selon la revendication 8, **caractérisé en ce que** le second matériau est appliqué sur la face intérieure du boîtier avec une épaisseur plus grande que sur le segment orienté vers un élément de boîtier et/ou sur la face extérieure du boîtier.

10. Elément de boîtier d'un boîtier de blindage comprenant une sous-partie de boîtier (1, 1') et un couvercle de boîtier (2) avec un joint appliquée directement sur l'élément de boîtier, le joint étant un joint électriquement conducteur et étant d'un profil d'étanchéité et de protection en forme de cordon, constitué d'un premier matériau et d'un deuxième matériau, le premier matériau étant essentiellement non conducteur avec des propriétés adaptées à une bonne action d'étanchéité, et le deuxième matériau étant un composant ayant des propriétés adaptées à une bonne action de protection par des inclusions électriquement conductrices, le premier matériau formant un cordon entouré complètement par un cordon du deuxième matériau, le profil d'étanchéité et de protection étant appliqué par une aiguille et/ou une buse avec un premier canal étant entouré complètement par un second canal.

11. Elément de boîtier selon la revendication 10, **caractérisé en ce que** les inclusions électriquement conductrices utilisées pour le deuxième composant sont des particules, notamment des fibres ou des plaquettes en métal ou en alliage ayant une conductibilité électrique élevée, notamment de l'argent ou un alliage argentifère.

12. Elément de boîtier selon la revendication 10, **caractérisé en ce que** le premier composant contient une matière de charge non conductrice, en particulier oxydée ou en céramique.

13. Elément de boîtier selon l'une des revendications 10 à 12, **caractérisé en ce qu'**un agent adhésif est mélangé au premier et/ou au deuxième composant.

14. Elément de boîtier selon l'une des revendications 10 à 13, **caractérisé en ce que** le cordon du premier composant est essentiellement de section circulaire et entouré de manière concentrique au moins par secteurs par le cordon du deuxième composant, celui-ci ayant essentiellement une section circulaire segmentée.

15. Elément de boîtier selon l'une des revendications 10 à 14, **caractérisé en ce que** le deuxième composant a une épaisseur irrégulière dans la section du profil.
